# EUROPÄISCHE PATENTSCHRIFT

(11) **EP 1 645 897 B1**
(45) Veröffentlichungstag und Bekanntmachung des Hinweises auf die Patenterteilung: **17.06.2009**
(21) Anmeldenummer: 04090388.2
(22) Anmeldetag: 08.10.2004
(51) Int. Cl.: G02B 6/42, H01L 31/0203

(54) **Verfahren zum Herstellen eines mit einem Kunststoffgehäuse versehenen optischen oder elektronischen Moduls**
Method of fabrication of an optical or electronic module comprising a plastic housing
Procédé de fabrication d'un module optique ou électronique comprenant un boîtier plastique

(43) Veröffentlichungstag der Anmeldung: 12.04.2006
(73) Patentinhaber: Avago Technologies Fiber IP (Singapore) Pte. Ltd., Singapore 768923 (SG)
(72) Erfinder: Weigert, Martin, 93152 Hardt (DE); Hurt, Hans, 93049 Regensburg (DE)
(74) Vertreter: Dilg, Haeusler, Schindelmann Patentanwaltsgesellschaft mbH

(56) Entgegenhaltungen:
- EP-A- 0 435 468
- EP-A- 1 622 204
- DE-B3- 10 250 540
- US-A- 5 500 540
- US-A1- 2003 117 482
- US-A1- 2004 008 952
- PATENT ABSTRACTS OF JAPAN Bd. 006, Nr. 170 (E-128), 3. September 1982 (1982-09-03) & JP 57 085273 A (TOSHIBA CORP), 27. Mai 1982 (1982-05-27)

## Beschreibung

Die Erfindung betrifft ein Verfahren zum Herstellen eines mit einem Kunststoffgehäuse versehenen optischen oder elektronischen Moduls, bei dem eine mit der Umgebung in Wirkverbindung stehende Komponente nach dem Umhüllen der Modulkomponenten mit einer Kunststoffmasse in einem sich daran anschließenden Verfahrensschritt teilweise wieder freigelegt wird.

Es ist bekannt, optoelektronische Module mit einem transparenten Vergussmaterial zu vergießen. So ist beispielsweise aus der DE 199 09 242 A1 ein opto-elektronisches Modul bekannt, bei dem ein Leadframe mit einem optoelektronischen Wandler in einem Modulgehäuse positioniert und mit einem lichtdurchlässigen, formbaren Kunststoffmaterial vergossen wird. Eine Lichtein- oder Auskopplung erfolgt über eine Lichtleitfaser, die an einem Stutzen des Modulgehäuses angekoppelt wird. Auf dem Leadframe befindet sich auch der Treiberbaustein bzw. Empfangsbaustein für den optoelektronischen Wandler.

Aus der DE 102 50 540 B3 ist ein Verfahren zur Herstellung eines optoelektronischen Bauteils bekannt, bei dem ein optoelektronischer Wandler in einen strahlungstransparenten Formkörper eingebettet wird, in den eine strahlungsoptische Funktionsfläche eingebaut wird.

Allerdings weist die Verwendung von Vergussmaterialien, die für den jeweiligen Wellenlängenbereich transparent sind, insofern Nachteile auf, als transparente Vergussmaterialien in der Regel einen hohen thermischen Ausdehnungskoeffizienten besitzen und dementsprechend bei großen Temperaturschwankungen Spannungen im Package auftreten, die insbesondere die empfindlichen Bonddraht-Verbindungen beschädigen können.

Es ist daher grundsätzlich vorteilhaft, für ein Vergießen oder Verpressen der Komponenten eines Moduls nichttransparente Kunststoffmaterialien einzusetzen, die mit Füllstoffen versehen sind, die einen günstigen thermischen Ausdehnungskoeffizienten des Kunststoffmaterials bereitstellen. Nachteilig bei der Verwendung solcher Kunststoffe als Vergussmaterial ist, dass innerhalb des Vergussmaterials kein optischer Pfad realisiert werden kann.

Ein weiteres Problem besteht darin, an ein mit einer Vergussmasse vergossenes Modul weitere Komponenten wie eine Lichtleitfaser oder ein optisches Element derart anzukoppeln, dass eine gute Kopplung mit dem optoelektronischen Wandler vorliegt.

Vergleichbare Probleme können sich auch bei rein elektronischen, mit einem Kunststoffgehäuse versehenen Modulen ergeben, sofern das Erfordernis besteht, eine Komponente des Moduls in Wirkverbindung mit der Umgebung zu bringen.

Der vorliegenden Erfindung liegt die Aufgabe zu Grunde, ein Verfahren zum Herstellen eines mit einem Kunststoffgehäuse versehenen optischen oder elektronischen Moduls bereitzustellen, das es ermöglicht, eine vergossene Komponente des Moduls in Wirkverbindung mit der Umgebung zu bringen und in effektiver Weise mit weiteren Komponenten zu koppeln.

Diese Aufgabe wird erfindungsgemäß durch ein Verfahren mit den Merkmalen des Anspruchs 1 gelöst. Bevorzugte und vorteilhafte Ausgestaltungen der Erfindung sind in den Unteransprüchen angegeben.

Es ist vorgesehen, die Komponente nach dem Umhüllen mit einem Kunststoffmaterial mittels einer Vorrichtung zum partiellen Entfernen des Kunststoffmaterial wieder freizulegen, d. h. dass die Komponente abdeckende Kunststoffmaterial zumindest partiell wieder zu entfernen, damit sie in Wirkverbindung mit der Umgebung treten kann. Dabei zeichnet sich die erfindungsgemäße Lösung dadurch aus, dass die Vorrichtung zum partiellen Entfernen der Kunststoffmasse gleichzeitig eine Funktionsstruktur in die verbleibende Kunststoffmasse einbringt. Eine solche Funktionsstruktur ermöglicht insbesondere eine passive Justage und/oder Befestigung einer anzukoppelnden Komponente in Bezug auf das Modul und die optische oder elektrische Komponente. Bei der anzukoppelnden Komponente handelt es sich beispielsweise um eine Lichtleitfaser bzw. einen optischen Stecker oder um ein optisches Element wie ein Fenster, eine Umlenkvorrichtung, ein Prisma; einen Filter, eine Linse und dergleichen. Die Funktionsstruktur muss sich aber nicht notwendigerweise auf ein anzukoppelnden Element beziehen, sondern kann auch allein Funktionalitäten des Moduls selbst wie etwa die Bereitstellung von Ausgleichsbereichen zur Aufnahme von Kunststoffmaterial oder die Bereitstellung von Belüftungsschächten betreffen.

Es wird darauf hingewiesen, dass ein Umhüllen des Moduls nicht notwendigerweise mit nur einer Kunststoffmasse erfolgt. Sofern ausschließlich eine nichttransparente Kunststoffmasse zum Umhüllen verwendet wird, wird der Wirkbereich der Komponente vollständig freigelegt.

Unter einem Wirkbereich der optischen oder elektrischen Komponente wird jeder Bereich bezeichnet, der eine Wirkverbindung der Komponente mit der Umgebung ermöglicht. Beispielsweise handelt es sich um den photosensitiven Bereich einer Photodiode, um den Sensorbereich eines Drucksensors oder eines Temperatursensors, um den lichtemittierenden Bereich eines Halbleiterlasers oder einer LED oder um die der Modul-Außenseite zugewandte Fläche einer Linse, eines Spiegels oder eines Prismas.

In einer bevorzugten Ausgestaltung ist vorgesehen, dass vor nach dem partiellen Entfernen der Kuntststoffmasse die Position der Komponente durch direkte oder indirekte Messung erfasst wird, wobei die Funktionsstruktur in definierter Position relativ zu der erfassten Position der Komponente in die Kunststoffmasse eingeschrieben wird. Dies ermöglicht es, die Funktionsstruktur exakt auf die Komponente auszurichten, so dass ein weitere Element wie eine Lichtleitfaser mittels der Funktionsstruktur passiv gegenüber der Komponente justiert werden kann.

Eine direkte Messung der Position der Komponente bedeutet, dass deren Lage in Bezug auf ein außerhalb des Moduls liegendes externes Koordinatensystem durch Messung direkt erfasst wird. Bei einer indirekten Messung der Position stellt dagegen das Modul selbst bzw. ein Element des Moduls wie ein Leadframe das Koordinaten- und Referenzsystem für die Positionsbestimmung der Komponente dar. Die relative Lage wird beispielsweise bei dem Befestigen der Komponente auf dem Leadframe erfasst und gespeichert, so dass die Information beim Einschreiben einer Funktionsstruktur in das Gehäuse zur Verfügung steht. Ein Beispiel für eine direkte Messung der Position der Komponente ist die Positionserfassung mittels eines Bilderkennungssystems, beispielsweise unter Verwendung eines Kamerasystems und eines zugeordneten Computers. Die so erhaltenen Informationen über die Lage der Komponente dienen dabei als Referenz für das Anbringen der Funktiönsstrukturen. Eine besonders genaue Ausrichtung der Funktionsstrukturen in Bezug auf die Komponente ist dabei dann möglich, wenn erst nach dem Freilegen der Komponente deren Lage genau bestimmt wird. Eventuelle Ungenauigkeiten bei dem Öffnen des Moduls (d.h. die Komponente liegt nicht - wie es gewünscht ist - mittig in der Öffnung) können dann durch Ausrichten der Funktionsstrukturen auf die tatsächliche Lage der Komponente noch korrigiert werden.

Weitere Möglichkeiten der Positionserfassung der Komponente sind eine Messung mittels einer Ultraschall-Messvorrichtung oder einer Röntgenstrahl-Messvorrichtung.

Es wird darauf hingewiesen, dass alternativ die Funktionsstruktur auch in definierter Position relativ zu der Öffnung in die Kunststoffmasse eingeschrieben werden kann, die beim partiellen Entfernen der Kunststoffmasse im Kunststoffgehäuse entsteht. Hier dient nicht die Komponente, sondern die Öffnung als Referenz für die Funktionsstruktur. Dies ist insbesondere dann sinnvoll, wenn die Funktionalität der Funktionsstruktur mit der Öffnung selbst in Zusammenhang steht. Die Information über die Lage der Öffnung steht der Vorrichtung zum partiellen Entfernen des Kunststoffmaterials natürlich zur Verfügung, so dass eine solche Ausrichtung der Funktionsstruktur leicht zu verwirklichen ist.

In einer bevorzugten Ausgestaltung umfasst wie bereits erwähnt die Funktionsstruktur mindestens eine Justagestruktur, die eine passive Justage eines an das Modul anzukoppelnden Elements in Bezug auf die Komponente ermöglicht. Die Justagestruktur umfasst beispielsweise mindestens eine Justagemarke, die in die Oberfläche des Kunststoffgehäuses eingeschrieben ist und eine passive Justage eines anzukoppelnden Elementes ermöglicht.

Des weiteren kann vorgesehen sein, dass die Justagestruktur neben einer Justage auch unmittelbar einer Befestigung des anzukoppelnden Elements dient. Für diesen Fall umfasst die Justagestruktur Befestigungsstrukturen, die eine Befestigung eines anzukoppelnden Elements in definierter Position an dem Kunststoffgehäuse ermöglichen. Eine solche Befestigungsstruktur ist beispielsweise eine Bohrung bzw. ein Sackloch, das in das Kunststoffgehäue eingeschrieben wird. Auch kann es sich bei der Befestigungsstruktur um einen Gehäusestutzen handeln, der in das Kunststoffgehäuse eingeschrieben wird und der der direkten Ankopplung eines optischen Steckers dient. Insbesondere handelt es sich um den Ankoppelstutzen eines CAI (Cavity as Interface) Gehäuses.

In einer bevorzugten Ausgestaltung der Erfindung ist vorgesehen, dass die Öffnung, die beim partielles Entfernen der Kunststoffmasse im Kunststoffgehäuse entsteht, nach dem Freilegen der Komponente mit einem transparenten Vergussmaterial gefüllt wird. Hierzu kann z.B. Silicon als Vergussmasse verwendet werden. Das Befüllen der Öffnung mit einem Vergussmaterial birgt allerings die Gefahr der Luftblasenbildung und damit einer Verschlechterung einer optischen Kopplung mit der Komponente mit sich. Um dies zu vermeiden, ist in einem weiteren Erfindungsaspekt vorgesehen, dass die Funktionsstruktur mindestens einen Lüftungsschacht aufweist, der sich angrenzend an die Öffnung im Kunststoffgehäuse von der Oberfläche des Kunststoffgehäuses in das Innere des Kunststoffgehäuse erstreckt. Durch diesen Lüftungsschacht können beim Befüllen entstehende Luftblasen verbessert entweichen.

Des weiteren kann vorgesehen sein, dass seitlich der Öffnung in die Oberfläche des Kunststoffgehäuse als Funktionsstrukturoder Teil der Funktionsstruktur eine flache Aussparung ausgebildet wird, die als Ausgleichsbehältnis für das transparente Vergussmaterial dient, dass in die Öffnung eingefüllt wird.

Die optische oder elektronische Komponente wird bevorzugt vor dem Umhüllen auf einem Träger angeordnet. Der Träger des Moduls ist bevorzugt als Leadframe, auch als Metallträger oder Stanzgitter bezeichnet, ausgebildet. Das Leadframe weist dabei bevorzugt mindestens einen planen Trägerbereich, auch als "die pad" oder "Chipinsel" bezeichnet, sowie eine Mehrzahl von Kontaktbeinen auf, die sich am Randbereich des Leadframes befinden. Die optische oder elektronische Komponente wird dabei jeweils auf einem Trägerbereich angeordnet. Grundsätzlich können statt eines Leadframes aber auch beliebige andere Träger eingesetzt werden, beispielsweise Träger, die aus einer strukturierten Kunststofffolie bestehen oder aus einer Leiterplatte. Auch kann auf einen gesonderten Träger grundsätzlich ganz verzichtet werden.

Die optische Komponente ist bevorzugt ein opto-elektronisches Sendebauelement oder ein opto-elektronisches Empfangsbauelement, insbesondere eine Photodiode oder eine LED oder ein Halbleiterlaser. Jedoch kann es sich bei dem optischen Bauelement beispielsweise auch um eine Linse, einen optischen Filter, ein Prisma, einen Spiegel oder dergleichen handeln. Sofern es sich bei der Komponente um eine elektronische Komponente handelt, ist diese bevorzugt ein Sensor, insbesondere ein Drucksensor oder ein Temperatursensor.

Zum partiellen Entfernen der Kunststoffmasse wird beispielsweise eine Fräsvorrichtung oder eine Laser-Abtragvorrichtung verwendet. Dabei spielt der konkrete Aufbau der Vorrichtung keine Rolle. Die Vorrichtung muss lediglich ein definiertes partielles Abtragen des Kunststoffmaterial ermöglichen.

Der Schritt des Umhüllens mit Kunststoffmasse umfasst bevorzugt ein Vergießen oder Verpressen der Komponente mit der Kunststoffmasse. Das Vergießen oder Verpressen kann dabei in einem speziellen Werkzeug, insbesondere einem Spritzgusswerkzeug erfolgen.

Die Erfindung wird nachfolgend unter Bezugnahme auf die Figuren anhand eines Ausführungsbeispieles näher erläutert.
Es zeigen:
- Figur 1: eine Schnittansicht eines optischen Moduls mit einer optischen Komponente während der Herstellung des Moduls und nach Vergießen des Moduls mit einer Kunststoffmasse;
- Figur 2: das fertige optische Modul, hergestellt nach dem Verfahren der vorliegenden Erfindung;
- Figur 3: in Frontansicht ein Modul mit einer in das Kunststoffgehäuse eingebrachten, eine optische Komponente freilegenden Öffnung sowie einer Dreipunktverankerung zur Ankopplung eines optischen Steckers am Modul, wobei die Dreipunktverankerung in Bezug auf die optische Komponente ausgerichtet ist;
- Figur 4A: ein mit einer eine optische Komponente freilegenden Öffnung versehenes Modul, wobei seitlich der Öffnung zwei Entlüftungsschächte in der Kunststoffmasse des Moduls ausgebildet sind;
- Figur 4B: eine schematische Draufsicht auf die Öffnung'und die Entlüftungsschächte der Figur 3A;
- Figur 4C: eine Schnittansicht des Moduls der Figur 3A im Bereich der Öffnung und der Entlüftungsschächte;
- Figur 5: eine Schnittdarstellung eines mit einer Öffnung versehenen optischen Moduls, das gelaserte Sacklöcher zur Ankopplung eines ebenfalls dargestellten optischen Elementes aufweist;
- Figur 6: eine Schnittdarstellung eines mit einer Öffnung versehenen optischen Moduls, an das ein schematisch dargestelltes optisches Element angekoppelt ist;
- Figur 7: ein Ausführungsbeispiel eines optoelektronischen Moduls, bei dem als in das Kunststoffgehäuse eingebrachte Funktionsstruktur ein vorstehender Stutzen vorgesehen ist, der eine Schnittstelle zur Ankopplung eines Fasersteckers bereitstellt; und
- Figur 8: einen Faserstecker, der zur Kopplung mit dem optoelektronischen Modul der Figur 7 geeignet ist.

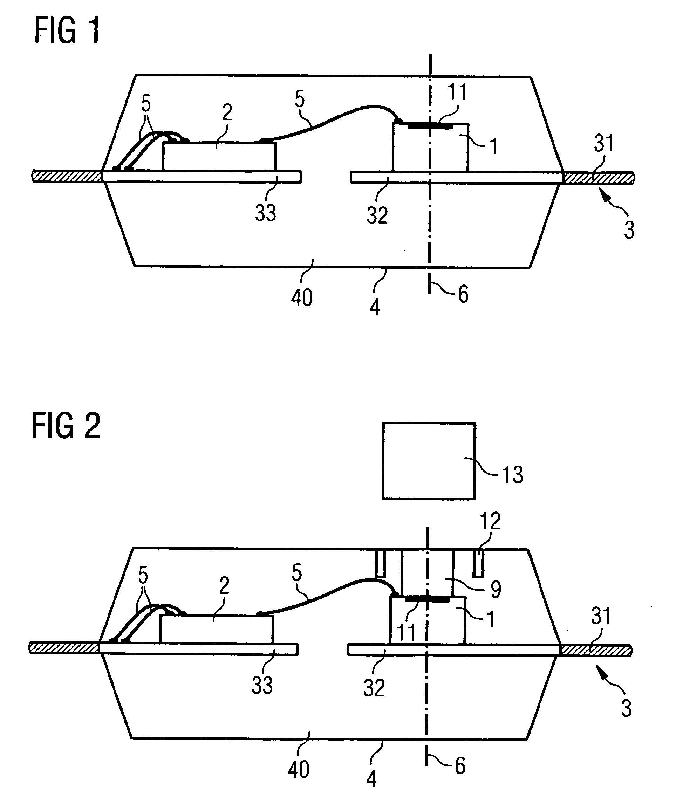

Die Figur 1 zeigt ein optisches Modul mit einer optischen Komponente 1 und einem zugeordneten elektronischen Baustein 2, die auf einem Leadframe 3 angeordnet und mit einer nicht transparenten Kunststoffmasse 40, die ein Kunststoffgehäuse 4 bereitstellt, vergossen sind.

Bei der optischen Komponente 1 handelt es sich beispielsweise um eine Lumineszenzdiode (LED), einen Halbleiterlaser oder eine Photodiode. Bei dem elektronischen Baustein 2 handelt es sich beispielsweise um einen Treiber oder einen Vorverstärker. Die optische Komponente 2 ist bevorzugt als vorgefertigter Chip ausgebildet. Der elektronische Baustein 2 ist bevorzugt als integrierter Schaltkreis (IC) ausgebildet.

Der Leadframe 3 weist zwei plane Trägerflächen 32, 33 auf, die auch als "die pad" bezeichnet werden und auf denen zum einen die optische Komponente 1 und zum anderen der elektronische Baustein 2 angeordnet sind. Des weiteren besitzt der Leadframe 3 an seinem Rand eine Mehrzahl von Kontaktbeinen (leads). Die Kontaktbeine stehen dabei aus der Vergussmasse 4 hervor. Derartige Leadframes 3 sind im Stand der Technik bekannt, so dass hierauf nicht weiter eingegangen wird.

Auf den beiden Trägerflächen 32, 33 sind die optische Komponente 1 und der elektronische Baustein 2 angeordnet. Eine elektrische Kontaktierung dieser Modulkomponenten 1, 2 erfolgt zum einen durch einen Kontakt auf der Unterseite, der direkt mit der jeweiligen Trägerfläche 32, 33 elektrisch verbunden ist, sowie zum anderen über Bonddrähte 5.

Die optische Komponente 1 weist an ihrer Oberseite eine Wirkfläche 11 auf. Beispielsweise handelt es sich um eine lichtemittierende Fläche 11 eines LED-Chips.

Die Kunststoffmasse 40 ist zur Bereitstellung eines günstigen thermischen Ausdehnungskoeffizienten mit einem Füllstoff versehen und daher nicht transparent für das emittierte oder empfangene Licht. Der optische Pfad des optischen Bauelements 1 ist verschlossen.

Es ist daher vorgesehen, in einem weiteren Verfahrensschritt eine Öffnung 9 in die Kunststoffmasse 40 einzubringen, so dass die Wirkfläche 11 der optischen Komponente 1 freigelegt und die optische Komponente 1 in Wirkverbindung mit der Umgebung treten kann. Das entsprechend fertig gestellte Modul ist in der Figur 2 dargestellt.

Zur Ausbildung einer Öffnung 9 in der Kunststoffmasse 40 ist die Verwendung einer Laser-Abtragvorrichtung 13 vorgesehen, die in der Figur 2 als Funktionsblock dargestellt ist. Die Laser-Abtragvorrichtung 13 umfasst in einer beispielhaften Ausgestaltung einen Laser, beispielsweise einen Nd:YAG-Laser, der Licht einer Wellenlänge von 1064 nm emittiert, sowie eine dem Laser zugeordnete Spiegeltrommel. Der Laser ist dabei derart angeordnet, dass der vom Laser emittierte Strahl auf die sich drehende Spiegeltrommel fällt. Die Spiegeltrommel weist einen polygonalen Querschnitt auf, so dass beim Drehen der Spiegeltrommel um eine horizontale Längsachse der Laserstrahl in einem begrenzten Laserstrahlbereich abgelenkt wird, wobei sich die Öffnung 9 in der nicht transparenten Kunststoffmasse 40 bildet. Durch geeignete Spiegelflächen der Spiegeltrommel wird dabei erreicht, dass der Laserstrahl sich flächig auf der Kunststoffmasse erstreckt, so dass eine dreidimensionale Laserabtragöffnung in dem Kunststoffgehäuse 4 eingegraben wird.

Abhängig von der genauen Ausgestaltung der Laser-Abtragvorrichtung kann die Öffnung 9 dabei unterschiedliche Ausgestaltungen aufweisen. In der Regel wird die in der Figur 2 lediglich schematisch dargestellte Laserabtragöffnung 9 trichterförmig ausgebildet sein.

Die Ausbildung einer Öffnung 9 im Kunststoffgehäuse unter Verwendung einer Laser-Abtragvorrichtung weist den Vorteil auf, dass eine Öffnung mit hoher Präzision in die Kunststoffmasse 40 eingebracht werden kann.

Es ist des Weiteren in dem Kunststoffgehäuse 4 eine Funktionsstruktur 12 ausgebildet, die durch die Laser-Abtragvorrichtung 13 (oder alternativ durch eine geeignete Fräsvorrichtung) in die Kunststoffmasse 40 eingebracht ist. Die Funktionsstruktur 12 ist in der Figur 2 lediglich schematisch und beispielhaft in Form von Bohrungen 12 dargestellt. Die Bohrungen 12 sind in Bezug auf die optische Komponente 1 ausgerichtet und dienen im dargestellten Ausführungsbeispiel der passiven Justage und Befestigung eines (nicht dargestellten) optischen Steckers an das Modul.

Dabei ist bevorzugt vorgesehen, dass die exakte Lage der Komponente 1 und deren Wirkfläche 11 nach dem Öffnen des Gehäuses durch die Laser-Abtragvorrichtung 13 ermittelt wird. Es kann dann mittels der Laser-Abtragvorrichtung 13 exakt zu dieser ermittelten Position eine Justage- und Befestigungsstruktur (in Form der Bohrungen 12 oder in anderer Weise) in das Kunststoffgehäuse 4 eingebracht werden, so dass auch mittels einer passiven Justage eine exakte Ausrichtung einer Lichtleitfaser oder eines anderen optischen Elementes in Bezug auf die Komponente 1 und deren Wirkfläche 11 erfolgen kann. Das Verfahren ist dabei sehr effektiv, da die Funktionsstrukturen 12 unmittelbar durch die Vorrichtung 13 in das Kunststoffgehäuse 4 eingebracht werden, die auch die Öffnung 9 bereitstellt.

Das beschriebene Verfahren ermöglicht eine passive Justage eines an das Modul anzukoppelnden Elementes und vermeidet somit eine aufwändige aktive Justage.

Alternativ kann auch vorgesehen sein, dass die exakte Lage der Komponente 1 direkt nach dem Anbringen der Komponente 1 auf dem Leadframe 3 (also vor dem Vergießen mit der Kunststoffmasse 40) erfasst und diese Lage dann dokumentiert wird. Abhängig von der Ablagegenauigkeit des dabei eingesetzten "Diebonders" erfolgt auch hier die Anbringung von Funktionsstrukturen an dem Modulgehäuse 4 in definierter Lage. Auch ist es grundsätzlich denkbar, dass die Lage der optischen Komponente in Bezug auf Referenzflächen des Leadframes 3 ermittelt wird. Hierbei ist allerdings Voraussetzung, dass die Ablagegenauigkeit der Komponente 1 in Bezug auf das Leadframe 3 ausreichend genau ist und zu gewährleisten, dass mit Funktionsstrukturen, die auf diese Weise relativ zu der Komponente 1 ausgerichtet werden, noch eine passive Justage mit ausreichender Koppelgenauigkeit erfolgen kann.

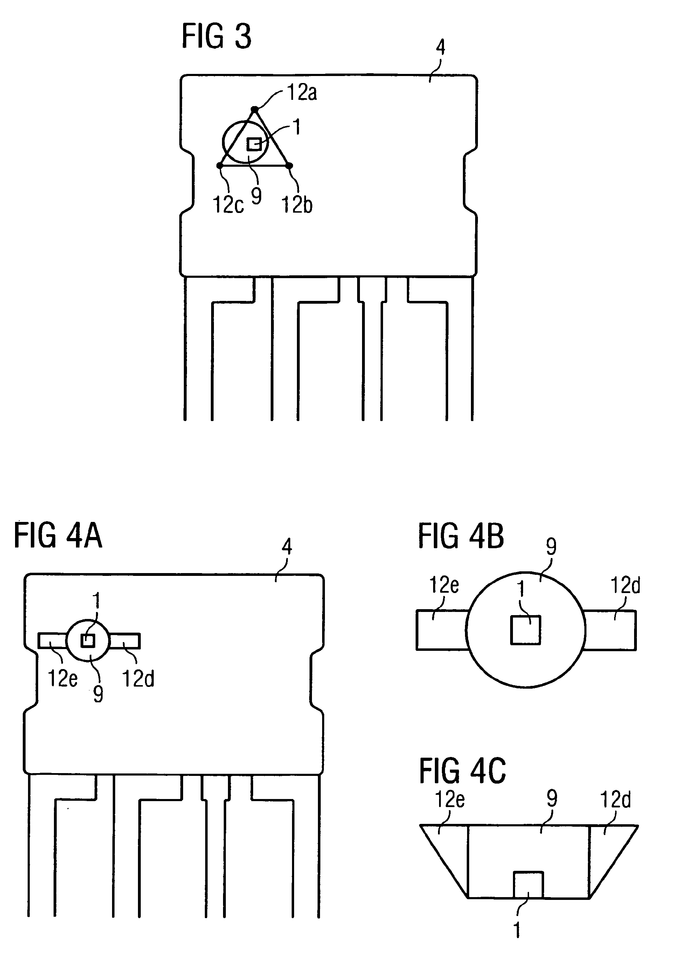

Die Figur 3 zeigt ein konkretes Ausführungsbeispiel, bei dem in der Kunststoffmasse 40 des Kunststoffgehäuses 4 des Moduls eine Öffnung 9 freigelasert ist. Durch die Öffnung 9 ist eine optoelektronische Komponente 1 freigelegt, die allerdings im dargestellten Ausführungsbeispiel nicht mittig in der Öffnung angeordnet ist, etwa aufgrund von Lagetoleranzen der Komponente 1 in Bezug auf das Leadframe 3. Es wird nun die tatsächliche Position der Komponente 1 etwa mittels eines Bildverarbeitungssystems erfasst und daraufhin in Bezug auf diese tatsächliche Lage eine Funktionsstruktur in Form einer Dreipunktverankerung (bestehend aus drei Bohrungen 12a, 12b, 12c) in die Kunststoffmasse 40 eingebracht. Ein optischer Stecker, der mittels der Dreipunktverankerung an das Modul angekoppelt wird, ist nun exakt in Bezug auf die eine Komponente 1 positioniert, ohne dass es einer aktiven Justage bedarf.

Die Figuren 4A bis 4C zeigen ein Ausführungsbeispiel, bei dem die Funktionsstruktur, die in das Kunststoffgehäuse 4 eingebracht ist, zwei Entlüftungsschächte 12d, 12e ausbildet, die seitlich der Öffnung 9 und an diese angrenzend sich von der Gehäuseoberfläche in das Modulinnere erstrecken. Wie der Schnittansicht der Figur 4C zu entnehmen ist, verjüngen sich dabei die Entlüftungsschächte 12d, 12e in Richtung der Komponente 1. Die Lüftungsschächte 12d, 12e sind dabei, anders als bei dem vorangehenden Ausführungsbeispiel der Figur 3, nicht in Bezug auf die Komponente 1, sondern in Bezug auf die in das Modul eingebrachte Öffnung 9 ausgerichtet, da sie direkt an diese angrenzen sollen. Sie dienen dazu, bei Einbringen einer transparenten Kunststoffmasse in die Öffnung 9 dafür zu sorgen, dass bei dem Einfüllen der transparenten Kunststoffmasse Luft seitlich entweichen kann und somit keine Luftblasen eingeschlossen werden. Es werden mittels der strukturgebenden Laser-Abtragvorrichtung 13 somit eine Art Luftleitungskanäle als Funktionsstruktur in das Kunststoffgehäuse 4 eingebracht.

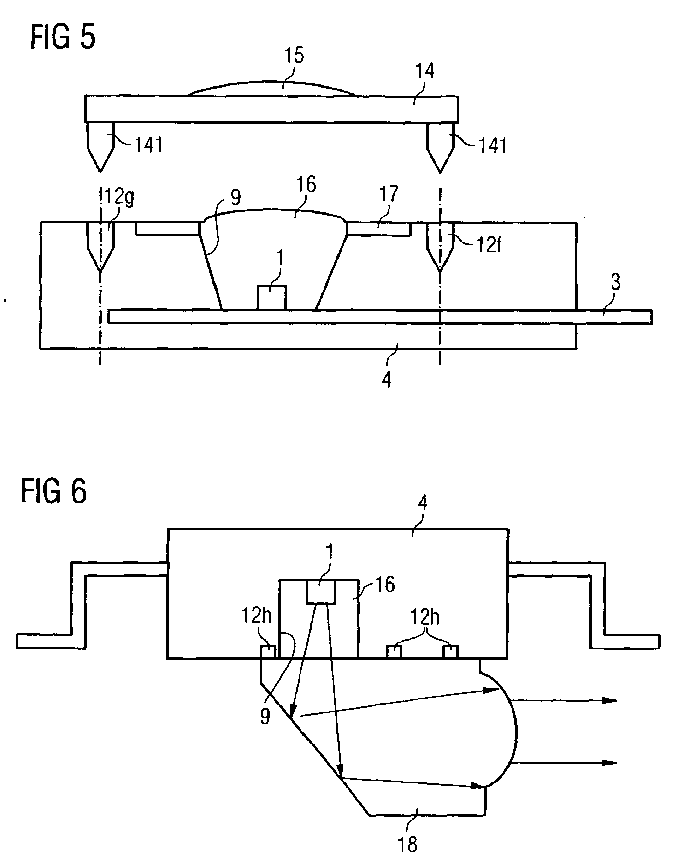

Die Figur 5 zeigt ein Ausführungsbeispiel, bei dem ein optisches Element 14 mit einer integrierten Linse 15 mittels vorstehender Führungsstifte 141 in gelaserte Sacklöcher 12f, 12g des Modulgehäuses eingebracht wird. Die freigelaserte Öffnung 9 ist dabei mit einem transparenten Kunststoff 16 gefüllt. Die Sacklöchter 12f, 12g sind vorzugsweise in Richtung zur optischen Komponente 1 ausgerichtet.

Des Weiteren ist als zusätzliche Funktionsfläche eine flache Aussparung 17 an der Oberfläche des Kunststoffgehäuses 4 vorgesehen, die sich angrenzend an die Öffnung 9 erstreckt und als Ausgleichbehältnis für die transparente Kunststoffmasse 16 dient. Wenn das optische Element 14 auf das Modul aufgesetzt wird, kann überstehende transparente Kunststoffmasse 16 in dieses Ausgleichbehältnis 17 ausweichen. Außerdem hat die transparente Kunststoffmasse (beispielsweise Silikon) aufgrund des Ausgleichbehältnisses 17 im Falle einer thermischen Ausdehnung ausreichend Platz sich auszudehnen, ohne eine starke mechanische Belastung auf das Bauteil auszuüben.

In dem Ausführungsbeispiel der Figur 5 ist das optische Element ein planes Fenster 14 mit integrierter Linse 15. Ebenso ist es jedoch denkbar, planparallele Platten, die z.B. als Blockfilter wirken, oder aber auch Umlenkvorrichtungen, Strahlteiler usw. über die Funktionsstrukturen 12f, 12g mit dem Modul zu verbinden.

Ein Ausführungsbeispiel hierzu zeigt die Figur 6, bei der die optische Komponente 1 ebenso wie im Ausführungsbeispiel der Figur 5 freigelasert ist und die dabei entstandene Öffnung 9 mit einem transparenten Kunststoffmaterial 16 gefüllt ist. Es ist über schematisch dargestellte Rastelemente 12h eine Umlenkvorrichtung 18 mit integrierter Linse an das Modul angebracht. Eine bevorzugte Anwendungsmöglichkeit dieser Ausgestaltung ist die Ankopplung von Licht in optische Leiterplatten.

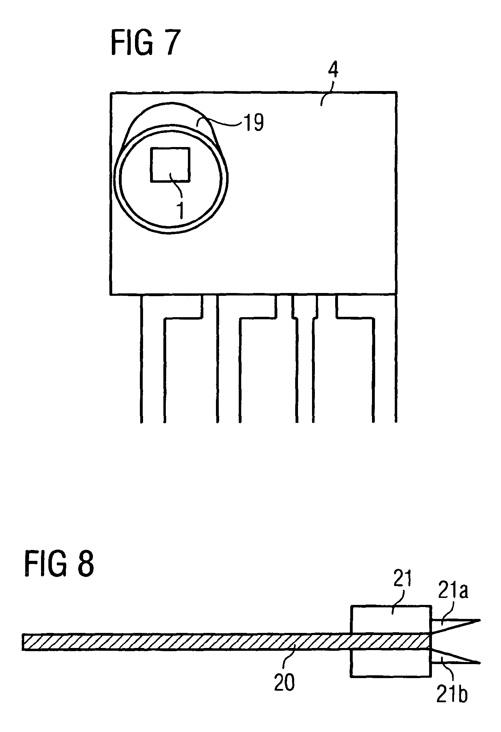

Die Figur 7 zeigt eine Modulausführung, die einen vorstehenden Gehäusestutzen 19 als Funktionsstruktur aufweist. Es liegt ein sogenanntes CAI- (cavity as interface) Modul vor. Der vorstehende Stutzen 19 dient der Faserführung und der Ankopplung eines optischen Steckers. Ein entsprechender optischer Stecker ist beispielhaft in der Figur 8 dargestellt. Der Lichtwellenleiter 20,ist an seinem Ende in einer Halterung 21 (auch als Insert bezeichnet) mit zwei vorstehenden Nasen 21a, 21b gehaltert. Der Insert 21 wird mit den Nasen 21a, 21b in das CAI-Modul und zwar in den Koppelstutzen 19 eingesteckt. Die Verbindung kann beispielsweise über einen Bajonett-Verschluss erfolgen.

Bei der Bereitstellung eines Gehäusestutzens 19 an dem Gehäuse ist es erforderlich, ein relativ großes Volumen an Kunststoffmasse zu entfernen. Alternativ kann vorgesehen sein, dass der Stutzen 19 gesondert gefertigt und über an der optischen Komponente bereitgestellte Justagestrukturen an dem Gehäuse positioniert wird.

Es wird darauf hingewiesen, dass die Komponente 1 auch eine elekronische Komponente sein kann. Es kann es sich bei der Komponente 1 beispielsweise um einen Sensor-Chip handeln, insbesondere um einen Drucksensor oder einen Temperatursensor, wie sie in der Automobilindustrie Anwendung findet.

Des Weiteren wird darauf hingewiesen, dass das Modul mehrere optische oder elektronische Komponenten der beschriebenen Art aufweisen kann, wobei dann für mindestens eine der Komponenten Öffnungen und Funktionsstrukturen in das Modulgehäuse eingebracht werden.

Die Herstellung des optischen oder elektronischen Moduls erfolgt bevorzugt im Nutzen auf einem Multinest-Werkzeug, wobei nach Aushärten des Kunststoffmaterials sowie nach Freilegen der jeweiligen Komponenten und Anbringen der Funktionsstrukturen die einzelnen optischen oder elektronischen Module vereinzelt werden.

## Patentansprüche

1. Verfahren zum Herstellen eines mit einem Kunststoffgehäuse versehenen optischen oder elektronischen Moduls, mit folgenden Schritten:
- Bereitstellen mindestens einer optischen oder elektronischen Komponente (1), wobei die Komponente (1) einen Wirkbereich (11) aufweist, über den sie im fertigen Modul in Wirkverbindung mit der Umgebung steht,
- Umhüllen der mindestens einen Komponente (1) ausschließlich mit einer lichtundurchlässigen Kunststoffmasse (40) zur Ausbildung des Kunststoffgehäuses (4),
- partielles Entfernen der Kunststoffmasse (40) von außen durch eine Vorrichtung (30) zum partiellen Entfernen der Kunststoffmasse derart, dass die Kunststoffmasse (40) zwischen dem Wirkbereich (11) der Komponente (1) und der Außenseite des Kunststoffgehäuses (4) zumindest teilweise derart entfernt wird, dass der Wirkbereich (11) vollständig freigelegt wird, und
- Einbringen einer Funktionsstruktur (12, 12a-12h, 17, 19) in die verbleibende Kunststoffmasse mittels der Vorrichtung (30).

2. Verfahren nach Anspruch 1, **gekennzeichnet durch** den weiteren Schritt, dass vor oder nach dem partiellen Entfernen der Kunststoffmasse (40) die Position der Komponente (1) **durch** direkte oder indirekte Messung erfasst wird, wobei die Funktionsstruktur (12, 12a-12c, 12f-12h, 19) in definierter Position relativ zu der erfassten Position der Komponente (1) in die Kunststoffmasse eingeschrieben wird.

3. Verfahren nach Anspruch 1, **gekennzeichnet durch** den weiteren Schritt, dass die Funktionsstruktur (12d, 12e, 17) in definierter Position relativ zu der Öffnung (9) in die Kunststoffmasse eingeschrieben wird, die beim partielles Entfernen der Kunststoffmasse (40) im Kunststoffgehäuse entsteht.

4. Verfahren nach mindestens einem der vorangehenden Ansprüche, **dadurch gekennzeichnet, dass** die Funktionsstruktur (12, 12a-12c, 12f-12h, 19) mindestens eine Justagestruktur umfasst, die eine passive Justage eines an das Modul anzukoppelnden Elements in Bezug auf die Komponente ermöglicht.

5. Verfahren nach Anspruch 4, **dadurch gekennzeichnet, dass** die Justagestruktur mindestens eine Justagemarke umfasst, die in die Oberfläche des Kunststoffgehäuses eingeschrieben ist.

6. Verfahren nach Anspruch 4 oder 5, **dadurch gekennzeichnet, dass** die Justagestruktur (12, 12a-12c, 12f-12h, 19) neben einer Justage auch einer Befestigung des anzukoppelnden Elements dient.

7. Verfahren nach Anspruch 6, **dadurch gekennzeichnet, dass** die Justagestruktur (12, 12a-12c, 12f-12h, 19) Befestigungsstrukturen umfasst, die eine Befestigung eines anzukoppelnden Elements in definierter Position an dem Kunststoffgehäuse (4) ermöglichen.

8. Verfahren nach Anspruch 7, **dadurch gekennzeichnet, dass** als Befestigungsstruktur (12, 12a-12c, 12f-12h) mindestens eine Bohrung in das Kunststoffgehäuse eingeschrieben wird.

9. Verfahren nach Anspruch 7, **dadurch gekennzeichnet, dass** als Befestigungsstruktur (19) ein Gehäusestutzen in das Kunststoffgehäuse eingeschrieben wird, der der direkten Ankopplung eines optischen Steckers (21) dient.

10. Verfahren nach mindestens einem der vorangehenden Ansprüche, **dadurch gekennzeichnet, dass** die Öffnung (9), die beim partielles Entfernen der Kunststoffmasse (40) im Kunststoffgehäuse entsteht, nach dem Freilegen der Komponente mit einem transparenten Vergussmaterial (16) gefüllt wird.

11. Verfahren nach Anspruch 10, **dadurch gekennzeichnet, dass** die Funktionsstruktur mindestens einen Lüftungsschacht (12d, 12e) aufweist, der sich angrenzend an die Öffnung (9) im Kunststoffgehäuse (4) von der Oberfläche des Kunststoffgehäuses in das Innere des Kunststoffgehäuses erstreckt.

12. Verfahren nach Anspruch 10 oder 11, **dadurch gekennzeichnet, dass** seitlich der Öffnung (9) in die Oberfläche des Kunststoffgehäuses (4) als Funktionsstruktur oder Teil der Funktionsstruktur eine flache Aussparung (17) ausgebildet wird, die als Ausgleichsbehältnis für das transparente Vergussmaterial (16) dient.

13. Verfahren nach mindestens einem der vorangehenden Ansprüche, **dadurch gekennzeichnet, dass** die optische oder elektronische Komponente (1) vor dem Umhüllen auf einem Träger (3) angeordnet wird.

14. Verfahren nach Anspruch 13, **dadurch gekennzeichnet, dass** der Träger als Leadframe (3) ausgebildet ist, der zum einen mindestens einen planen Trägerbereich (32) und zum anderen eine Mehrzahl von Kontaktbeinen (31) aufweist, die sich am Randbereich des Leadframes befinden, und wobei die optische oder elektronische Komponente (1) jeweils auf einem Trägerbereich (32) angeordnet wird.

15. Verfahren nach mindestens einem der vorangehenden Anspruche, **dadurch gekennzeichnet, dass** die optische Komponente (1) ein opto-elektronisches Sendebauelement oder ein opto-elektronisches Empfangsbauelement ist.

16. Verfahren nach mindestens einem der vorangehenden Ansprüche, **dadurch gekennzeichnet, dass** zum partiellen Entfernen der Kunststoffmasse (40) eine Laser-Abtragvorrichtung verwendet wird.

17. Verfahren nach mindestens einem der Ansprüche 1 bis 16, **dadurch gekennzeichnet, dass** zum partiellen Entfernen der Kunststoffmasse (40) eine Fräsvorrichtung verwendet wird.

## Claims

1. A method for producing an optical or electronic module provided with a plastic housing, comprising the following steps:
providing at least one optical or electronic component (1), the component (1) having an operative region (11), via which it is, in the finished module, in operative connection with the surroundings,
encasing the at least one component (1) exclusively with an opaque plastic composition (40) to form the plastic housing,
partial removal of the plastic composition (40) from the outside through a device (30) for partial removal of the plastic composition, such that the plastic composition (40) between the operative region (11) of the component (1) and the outer side of the plastic housing (4) is at least partially removed such that the operative region (11) is completely exposed, and
introducing a functional structure (12, 12a-12h, 17, 19) in the remaining plastic composition by means of the device (30).

2. Method according to claim 1, **characterized by** the further step that before or after the partial removal of the plastic composition (40) the position of the component (1) is detected by direct or indirect measurement, wherein the functional structure (12, 12a-12c, 12f-12h, 19) is inscribed in a defined position relative to the detected position of the component (1) .

3. Method according to claim 1, **characterized by** the further step, that the functional structure (12d, 12e, 17) is inscribed in defined position relative to the opening (9) which arises by removal of the plastic composition (40) in the plastic housing.

4. Method according to at least one of the preceding claims, **characterized in that** the functional structure (12, 12a-12c, 12f-12h, 19) comprises at least one adjustment structure which allows a passive adjustment of an element, to be coupled to the module, with respect to the component.

5. Method according to claim 4, **characterized in that** the adjustment structure comprises at least one adjustment mark inscribed in the surface of the plastic housing.

6. Method according to claim 4 or 5, **characterized in that** the adjustment structure (12, 12a-12c, 12f-12h, 19) serves, besides an adjustment, also for an attachment of the element to be coupled.

7. Method according to claim 6, **characterized in that** the adjustment structure (12, 12a-12c, 12f-12h, 19) comprises attachment structures which allow an attachment of an element to be coupled in defined position at the plastic housing (4).

8. Method according to claim 7, **characterized in that** at least one bore is inscribed in the plastic housing as attachment structure (12, 12a-12c, 12f-12h).

9. Method according to claim 7, **characterized in that** as the attachment structure (19) a housing stub is inscribed in the plastic housing which housing stub serves for the direct coupling of an optical plug (21).

10. Method according to one of the preceding claims, **characterized in that** the opening (9) which arises by partial removal of the plastic composition (40) in the plastic housing, is filled with a transparent casting material (16) after the exposure of the component.

11. Method according to claim 10, **characterized in that** the functional structure comprises at least one ventilating duct (12d, 12e) which extends adjacent the opening (9) in the plastic housing (4) from the surface of the plastic housing into the interior of the plastic housing.

12. Method according to claim 10 or 11, **characterized in that** lateral to the opening (9) in the surface of the plastic housing (4) as functional structure or part of the functional structure a shallow recess (17) is formed which serves as equalizing repository for the transparent casting material (16).

13. Method according to at least one of the preceding claims, **characterized in that** the optical or electronic component (1) is positioned on a carrier (3) before said encasing.

14. Method according to claim 13, **characterized in that** the carrier is formed as a lead frame (3) which comprises on the one hand at least one planar carrier region (32) and on the other hand a plurality of contact legs (31) which are located at the edge region of the lead frame and wherein the optical or electronic component (1) is positioned respectively on a carrier portion (32).

15. Method according to at least one of the preceding claims, **characterized in that** the optical component (1) is an optoelectronic transmitting component or an optoelectronic receiving component.

16. Method according to at least one of the preceding claims, **characterized in that** for partial removal of the plastic component (40) a laser ablation device is used.

17. Method according to at least one of claims 1 to 16, **characterized in that** for partial removal of the plastic composition (40) a milling device is used.

## Revendications

1. Procédé de fabrication d'un module optique ou électronique pourvu d'un boîtier plastique, comprenant les étapes suivantes consistant à :
- mettre à disposition au moins un composant optique ou électronique (1), le composant (1) comprenant une zone d'action (11) par l'intermédiaire de laquelle il est en liaison fonctionnelle avec les composants environnants dans le module achevé,
- enrober le au moins un composant (1) exclusivement avec une masse de matière plastique opaque (40) pour former le boîtier plastique (4),
- retirer en partie la masse de matière plastique (40) de l'extérieur grâce à un dispositif (30) destiné à retirer en partie la masse de matière plastique de telle sorte que la masse de matière plastique (40) est au moins en partie retirée entre la zone d'action (11) du composant (1) et la face extérieure du boîtier plastique (4) de telle sorte que la zone d'action (11) est entièrement libérée, et
- introduire une structure de fonctionnement (12, 12a-12h, 17, 19) dans la masse de matière plastique restante au moyen du dispositif (30).

2. Procédé selon la revendication 1, **caractérisé par** l'autre étape consistant à détecter, avant ou après avoir en partie retiré la masse de matière plastique (40), la position du composant (1) par une mesure directe ou indirecte, la structure de fonctionnement (12, 12a-12c, 12f-12h, 19) étant inscrite dans la masse de matière plastique dans une position définie par rapport à la position détectée du composant (1).

3. Procédé selon la revendication 1, **caractérisé par** l'autre étape consistant à inscrire dans la masse de matière plastique la structure de fonctionnement (12d, 12e, 17) dans une position définie par rapport à l'ouverture (9) qui est établie dans le boîtier plastique lorsque la masse de matière plastique (40) est en partie retirée.

4. Procédé selon l'une quelconque des revendications précédentes, **caractérisé en ce que** la structure de fonctionnement (12, 12a-12c, 12f-12h, 19) comporte au moins une structure d'ajustement qui permet un ajustement passif d'un élément à coupler au module par rapport au composant.

5. Procédé selon la revendication 4, **caractérisé en ce que** la structure d'ajustement comporte au moins une marque d'ajustement qui est inscrite dans la surface du boîtier plastique.

6. Procédé selon la revendication 4 ou 5, **caractérisé en ce que** la structure d'ajustement (12, 12a-12c, 12f-12h, 19), en plus d'ajuster l'élément à coupler, sert à le fixer.

7. Procédé selon la revendication 6, **caractérisé en ce que** la structure d'ajustement (12, 12a-12c, 12f-12h, 19) comporte des structures de fixation qui permettent une fixation d'un élément à coupler dans une position définie sur le boîtier plastique (4).

8. Procédé selon la revendication 7, **caractérisé en ce qu'**au moins un alésage est inscrit dans le boîtier plastique en tant que structure de fixation (12, 12a-12c, 12f-12h).

9. Procédé selon la revendication 7, **caractérisé en ce qu'**un embout de boîtier, qui sert à coupler directement un connecteur optique (21), est inscrit dans le boîtier plastique en tant que structure de fixation (19).

10. Procédé selon l'une quelconque des revendications précédentes, **caractérisé en ce que** l'ouverture (9) qui est établie dans le boîtier plastique lorsque la masse de matière plastique (40) est retirée en partie, est remplie d'un matériau de remplissage (16) transparent une fois le composant dégagé.

11. Procédé selon la revendication 10, **caractérisé en ce que** la structure de fonctionnement comprend au moins une cheminée d'aération (12d, 12e) qui s'étend en jouxtant l'ouverture (9) dans le boîtier plastique (4) de la surface du boîtier plastique à l'intérieur du boîtier plastique.

12. Procédé selon la revendication 10 ou 11, **caractérisé en ce qu'**un évidement plat (17), qui sert de contenant d'expansion pour le matériau de remplissage transparent (16), est conçu à côté de l'ouverture (9) dans la surface du boîtier plastique (4) en tant que structure de fonctionnement ou partie de la structure de fonctionnement.

13. Procédé selon l'une quelconque des revendications précédentes, **caractérisé en ce que** le composant optique ou électrique (1) est disposé sur un support (3) avant l'enrobage.

14. Procédé selon la revendication 13, **caractérisé en ce que** le support est conçu comme une grille de connexion (3) qui comprend d'une part au moins une zone de support plane (32) et d'autre part une pluralité de jambes de contact (31), qui se situent sur la zone de bord de la grille de connexion, et le composant optique ou électronique (1) étant disposé respectivement sur une zone de support (32).

15. Procédé selon l'une quelconque des revendications précédentes, **caractérisé en ce que** le composant optique (1) est un élément d'émission optoélectronique ou un élément de réception optoélectronique.

16. Procédé selon l'une quelconque des revendications précédentes, **caractérisé en ce qu'**un dispositif d'enlèvement au laser est utilisé pour retirer en partie la masse de matière plastique (40).

17. Procédé selon l'une quelconque des revendications 1 à 16, **caractérisé en ce qu'**un dispositif de fraisage est utilisé pour retirer en partie la masse de matière plastique (40).
